(19) Europäisches Patentamt / European Patent Office / Office européen des brevets

(11) **EP 2 301 994 B1**

(12) **EUROPEAN PATENT SPECIFICATION**

(45) Date of publication and mention of the grant of the patent:
**30.08.2017 Bulletin 2017/35**

(51) Int Cl.:
*C08K 3/22* (2006.01)  *H01L 41/187* (2006.01)
*H01L 41/193* (2006.01)

(21) Application number: **10179929.4**

(22) Date of filing: **27.09.2010**

(54) **Polymer composite piezoelectric material and piezoelectric device using the same**

Piezoelektrisches Polymerverbundmaterial und piezoelektrische Vorrichtung damit

Matériau piézoélectrique polymère composite et dispositif piézoélectrique l'utilisant

(84) Designated Contracting States:
**AL AT BE BG CH CY CZ DE DK EE ES FI FR GB GR HR HU IE IS IT LI LT LU LV MC MK MT NL NO PL PT RO SE SI SK SM TR**

(30) Priority: **28.09.2009 JP 2009222083**

(43) Date of publication of application:
**30.03.2011 Bulletin 2011/13**

(73) Proprietor: **Fujifilm Corporation**
**Minato-ku**
**Tokyo (JP)**

(72) Inventors:
• **Sakashita, Yukio**
  **Kanagawa-ken (JP)**
• **Miyoshi, Tetsu**
  **Kanagawa-ken (JP)**
• **Sasaki, Tsutomu**
  **Kanagawa-ken (JP)**

(74) Representative: **Klunker IP**
**Patentanwälte PartG mbB**
**Destouchesstraße 68**
**80796 München (DE)**

(56) References cited:
• **T. TAKENAKA: "Lead-free piezoelectric ceramics based on perovskite structures", J. ELECTROCERAM., vol. 19 (2007), 24 February 2007 (2007-02-24), pages 259-265, XP002612618,**

**Description**

BACKGROUND OF THE INVENTION

Field of the Invention

The present invention relates to a polymer composite piezoelectric material, which is suitable for sensors, ultrasound probes, vibration-based power generators, etc, and a piezoelectric device using the piezoelectric material.

Description of the Related Art

Polymer piezoelectric materials are piezoelectric materials having characteristics of a polymer material, such as flexibility, impact resistance, workability, being able to provide a large-area material, etc. The polymer piezoelectric materials have a higher voltage output constant (piezoelectric g-constant) than inorganic piezoelectric materials, and have an acoustic impedance that is close to those of a human body and water. Therefore, application of the polymer piezoelectric materials to various sensors, ultrasonic transducers, such as an ultrasound probe and a hydrophone, damping materials (dampers), and vibration-based power generation is expected. In these fields of application, piezoelectric materials with a sufficient piezoelectric distortion constant (d-constant), which is indicative of an amount of distortion per unit electric field (transmission capability), and a sufficient g-constant, which is indicative of an intensity of induced electric field per unit stress (reception capability), or piezoelectric materials with the d-constant and the g-constant which are well-balanced are demanded.

As the polymer piezoelectric materials, piezoelectric polymers which have piezoelectricity in the polymeric materials themselves, such as polyvinylidene fluoride (PVDF), have been known. Such piezoelectric polymers, however, have a lower d-constant than those of inorganic piezoelectric materials, and cannot provide sufficient performance when they are used in the applications mentioned above.

On the other hand, a piezoelectric material-polymer composite piezoelectric material (polymer composite piezoelectric material, which is hereinafter referred to as "composite piezoelectric material"), which is provided with piezoelectricity by combining an inorganic piezoelectric material in a matrix of a polymer material, is a piezoelectric material that has both the above-described advantages characteristic to polymer materials and excellent piezoelectric performance (d-constant) of inorganic piezoelectric materials. Such a composite piezoelectric materials has attracted attention as a piezoelectric material that allows material design for various uses by changing the type of polymer forming the matrix, and the type or composition, connectivity, shape and composition ratio of the inorganic piezoelectric material.

As the piezoelectric material used in the composite piezoelectric material, one having high piezoelectric performance is obviously preferred, and a lead-based piezoelectric material, which has a particularly high d-constant, such as lead zirconate titanate ($Pb(Zr,Ti)O_3$: PZT), is mainly used.

However, since lead is a highly toxic element, environmental problems, such as soil pollution and air pollution, due to effluence from the waste product and the material being used during the manufacturing process and disposal after use are inevitable. Therefore, demand for lead-free products is also increasing with respect to the composite piezoelectric material. Current lead-free piezoelectric materials, however, have a lower d-constant than that of lead-based piezoelectric materials, and it is difficult to provide high piezoelectric performance which is comparable to the piezoelectric performance of lead-based composite piezoelectric materials.

A piezoelectric composite that is formed using a bismuth layered compound and a piezoelectric polymer (copolymer of PVDF and trifluoroethylene) is disclosed in Japanese Patent No. 3075447 (hereinafter, Patent Document 1). Further, a piezoelectric composite that is formed using (Bi, Na) $TiO_3$-$BaTiO_3$ (BNT-BT) and a piezoelectric polymer (copolymer of PVDF and trifluoroethylene) is disclosed in K-H Lam et al., "Piezoelectric and pyroelectric properties of (Bi0.5Na0.5) 0.94Ba0.06TiO3/P (VDF-TrFE) 0-3 composites", Composites: Part A, Vol. 36, pp. 1595-1599, 2005 (hereinafter, Non-Patent Document 1).

Both the piezoelectric composites disclosed in Patent Document 1 and Non-Patent Document 1 are lead-free materials, and are preferred in view of environmental friendliness. However, the piezoelectric composite disclosed in Patent Document 1 uses a bismuth layered compound as the inorganic piezoelectric material. Although the bismuth layered compound has a Curie point of 500 to 800°C, which is higher than that of PZT and thus is advantageous in thermal stability, the piezoelectric composite disclosed in Patent Document 1 does not achieve piezoelectric performance comparable to that of PZT. Similarly, although the material system disclosed in Non-Patent Document 1 provides relatively high pyroelectric performance, it does not achieve high piezoelectric performance.

SUMMARY OF THE INVENTION

In view of the above-described circumstances, the present invention is directed to providing a lead-free polymer composite piezoelectric material which has good piezoelectric performance and good thermal stability at room temperature.

The polymer composite piezoelectric material of the invention includes: a matrix of an organic polymer resin, and a piezoelectric material included in the matrix. The piezoelectric material contains a perovskite oxide (which may contain inevitable impurities) having a composition represented by general formula (PX) below:

$$(Bi_x, A_{1-x}) (B_y, C_{1-y})O_3 \qquad (PX),$$

wherein A represents an A-site element with an average ionic valence of two other than Pb, B represents a B-site element with an average ionic valence of three, C represents a B-site element with an average ionic valence greater than three, each of A, B and C is one or two or more metal elements, O is oxygen, B and C have different compositions from each other, $0.6 \leq x \leq 1.0$, $x-0.2 \leq y \leq x$, and a ratio of a total mole number of the A-site element to a mole number of the oxygen atom and a ratio of a total mole number of the B-site element to the mole number of the oxygen atom are respectively 1:3 as a standard; however, these ratios may be varied from the standard molar ratio within a range where a perovskite structure is provided.

The "polymer composite piezoelectric material" herein refers to a composite of a polymer matrix resin and a piezoelectric material, as stated in the "Description of the Related Art" section, and refers to one that is generally called "composite piezoelectric material" ("Ceramic Composite, Chapter 2, Ceramic-Plastic Composite Piezoelectric Material", edited by the Ceramic Society of Japan, published by Baifukan).

In the polymer composite piezoelectric material of the invention, the A-site element A may be at least one metal element selected from the group consisting of Mg, Ca, Sr, Ba, (Na, Bi) and (K, Bi). It should be noted that, with respect to the descriptions "(Na, Bi)" and "(K, Bi)" here, each combination of two elements in parenthesis has an average ionic valence of two. In this case, each combination contains equimolar amounts of Na or K with the ionic valence of one and Bi with the ionic valence of three, and thus both the combinations have the average ionic valence of two.

Further, the B-site element B may be at least one metal element selected from the group consisting of Al, Sc, Cr, Mn, Fe, Co, Ni, Cu, Ga, Y, In and Re (rare earth element).

In the polymer composite piezoelectric material of the invention, a piezoelectric distortion constant $d_{33}$ (pm/V) and a specific permittivity $\varepsilon_{33}$ of the piezoelectric material may satisfy expressions (1) and (2) below:

$$100 < \varepsilon_{33} < 1500 \qquad (1),$$

$$d_{33} \ (pm/V) > 12\sqrt{\varepsilon_{33}} \qquad (2).$$

The first number of each suffix of "$d_{33}$" and "$\varepsilon_{33}$" indicates a direction of an applied electric field and the second number of the suffix indicates a direction of distortion when three axes 1, 2 and 3 which are perpendicular to each other are defined, and these suffixes indicate a longitudinal vibration mode where the direction in which the distortion or stress is taken out is parallel to the direction of the applied electric field. Therefore, $d_{33}$ and $\varepsilon_{33}$ represent a piezoelectric distortion constant and a permittivity of the longitudinal vibration mode.

Further, the piezoelectric distortion constant $d_{33}$ and a voltage output constant $g_{33}$ of the piezoelectric material may satisfy expressions (3) and (4) below:

$$100 < d_{33} \ (pm/V) \qquad (3),$$

$$80 < g_{33} \ (\times 10^{-3} \ V \cdot m/N) \qquad (4),$$

wherein $g_{33}$ is a voltage output constant of the piezoelectric material.

In particular, in the piezoelectric material, the perovskite oxide may contain $BaTiO_3$ as a first component and $BiFeO_3$ as a second component.

Further, the perovskite oxide may contain a first component with a tolerance factor greater than 1.0 and a second component with a tolerance factor smaller than 1.0, and may satisfy, in general formula (PX), expression (5) below:

$$0.97 \leq TF(PX) \leq 1.02 \qquad (5),$$

wherein TF(PX) is a tolerance factor of the oxide represented by general formula (PX).

The "tolerance factor TF" herein is a factor represented by the expression below:

$$TF = (rA+rO)/\sqrt{2}(rB+rO),$$

wherein rA represents an average ion radius of the A-site, rB represents an average ion radius of the B-site, and rO represents an ion radius of oxygen.

The "ion radius" herein refers to so-called Shannon's ion radius (see R.D. Shannon, "Revised Effective Ionic Radii and Systematic Studies of Interatomic Distances in Halides and Chalcogenides", Acta Crystallogr, Vol. A32, pp. 751-767, 1976). The "average ion radius" is a quantity represented by $\Sigma CiRi$, where C is a mole fraction of an ion in a lattice site and R is an ion radius. However, with respect to the ion radius of 12-coordinate Bi, since no description is found in the above literature and it has strong covalent character, a "covalent radius" is used.

Each tolerance factor TF is logically obtained based on the above expression. At this time, even one that does not actually form a perovskite oxide by itself is obtained in the same manner. $(TF(BaTiO_3) = 1.062, TF(BiFeO_3) = 0.989)$. Then, the composition of general formula (PX) above may be determined to satisfy the relationship of expression (1) above.

Further, in general formula (PX), a difference $|M_A-M_B|$ between an average atomic mass $M_A$ of the A-site element and an average atomic mass $M_B$ of the B-site element may be greater than 145.

The polymer composite piezoelectric material of the invention may have 1-3 connectivity. The connectivity of the polymer composite piezoelectric material refers to connectivity of a composite proposed by Newnham et al. (R. E. Newnham et al., "CONNECTIVITY AND PIEZOELECTRIC-PYROELECTRIC COMPOSITES", Mater. Res. Bull., Vol. 13, pp. 525-536, 1978). Specifically, the connectivity is expressed as "m-n connectivity" with assuming that a polymer composite piezoelectric material is a dice-like aggregate and decomposing it along three axes, i.e., X-, Y- and Z-axes, where the number of axis(axes) among the three axes along which the piezoelectric material has self-connection is m, and the number of axis (axes) among the three axes along which the polymer has self-connection is n. The "1-3 connectivity" refers to a structure in which the piezoelectric material has self-connection only along one axis and the polymer has self-connection along all the three axes.

In a case where the polymer composite piezoelectric material of the invention is in the form of a polymer composite piezoelectric film formed on a substrate, the film may have a thickness not less than 1 $\mu$m and not more than 100 $\mu$m.

The piezoelectric device of the invention includes: the above-described polymer composite piezoelectric material of the invention; and a pair of electrodes for extracting an electric charge that is generated when the piezoelectric material is distorted by an external force.

The polymer composite piezoelectric material of the invention employs, as the piezoelectric material, a piezoelectric material containing a perovskite oxide (which may contain inevitable impurities) having a composition represented by general formula (PX). This perovskite oxide has first been found by the present inventors, who have invented a material design method to provide a lead-free perovskite oxide with high piezoelectric performance (d-constant), as a composition of a lead-free perovskite oxide having high piezoelectric performance that is nearly equal to the piezoelectric performance of lead-based perovskite oxides. Further, this perovskite oxide has a high Curie point, and thus has good thermal stability. Therefore, according to the invention, a lead-free polymer composite piezoelectric material which has good piezoelectric performance and good thermal stability at room temperature can be provided.

Further, the present inventors have found, through the above-mentioned material design, a composition with the d-constant and the g-constant which are sufficient and well-balanced. In order to maintain a high g-constant, which is one of the characteristics of the polymer composite piezoelectric material, it is preferred that the inorganic piezoelectric material used also has a high g-constant. Therefore, a polymer composite piezoelectric material with the d-constant and the g-constant which are sufficient and well-balanced and higher performance than ever before can be accomplished by using the piezoelectric material including this perovskite oxide (which may contain inevitable impurities).

BRIEF DESCRIPTION OF THE DRAWINGS

FIG. 1A is a perspective view illustrating the structure of a piezoelectric composite having 1-3 connectivity according to an embodiment of the present invention,

FIG. 1B is a perspective view illustrating the structure of a piezoelectric composite having 0-3 connectivity according to an embodiment of the invention,

FIG. 2 is a graph showing a relationship between permittivity and piezoelectric distortion constant of a lead-free piezoelectric material of the invention and existing piezoelectric materials using lead-based and lead-free materials,

FIG. 3 is a graph showing a relationship between piezoelectric distortion constant and voltage output constant of the lead-free piezoelectric material of the invention and the existing piezoelectric materials using lead-based and lead-free materials,

FIG. 4 is a graph showing a relationship among ion radius of an A-site element, ion radius of a B-site element, tolerance factor TF and crystal system for various perovskite oxides,

FIG. 5 is a schematic sectional view illustrating the structure of a piezoelectric device according to one embodiment of the invention,

FIG. 6 is a graph showing volume fraction dependency of permittivity $\varepsilon$ and piezoelectric constants $d_{33}$ and $g_{33}$ of a 1-3 composite using PZT, and

FIG. 7 is a graph showing results of XRD of a piezoelectric ceramic powder of Example 1.

## DESCRIPTION OF THE PREFERRED EMBODIMENTS

*Polymer Composite Piezoelectric Material (Piezoelectric Composite)*

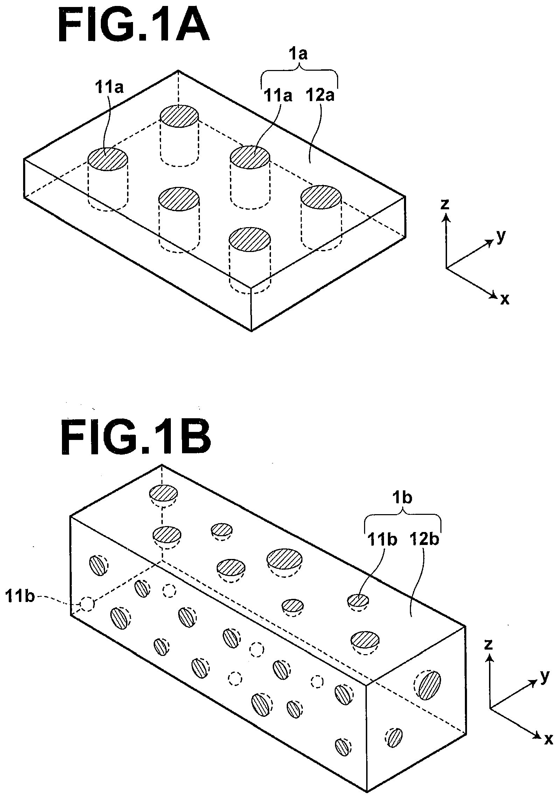

A polymer composite piezoelectric material (piezoelectric composite) according to one embodiment of the invention is described with reference to the drawings. FIG. 1A is a perspective view schematically illustrating a piezoelectric composite having 1-3 connectivity (which is hereinafter referred to as "1-3 composite"), and FIG. 1B is a perspective view schematically illustrating a piezoelectric composite having 0-3 connectivity (which is hereinafter referred to as "0-3 composite").

The 1-3 composite shown in FIG. 1A has a structure where a piezoelectric composite 1a includes a plurality of columnar (fiber-like) piezoelectric material bodies 11a arranged independently from each other in a polymer matrix 12a such that the long axis direction of the piezoelectric material bodies 11a is substantially parallel to the z-axis shown in the drawing. Each single columnar piezoelectric material body 11a has connectivity only along the z-axis direction, and the periphery of each column is covered with the polymer matrix 2.

The piezoelectric composite 1a can be produced using a common method for producing a 1-3 composite. For example, the piezoelectric composite 1a may be produced by producing an array of the columnar piezoelectric material bodies 11a using die casting or a multi-blade wafer ring saw for wafer production, and pouring a polymer resin between the array of the piezoelectric material bodies 11a.

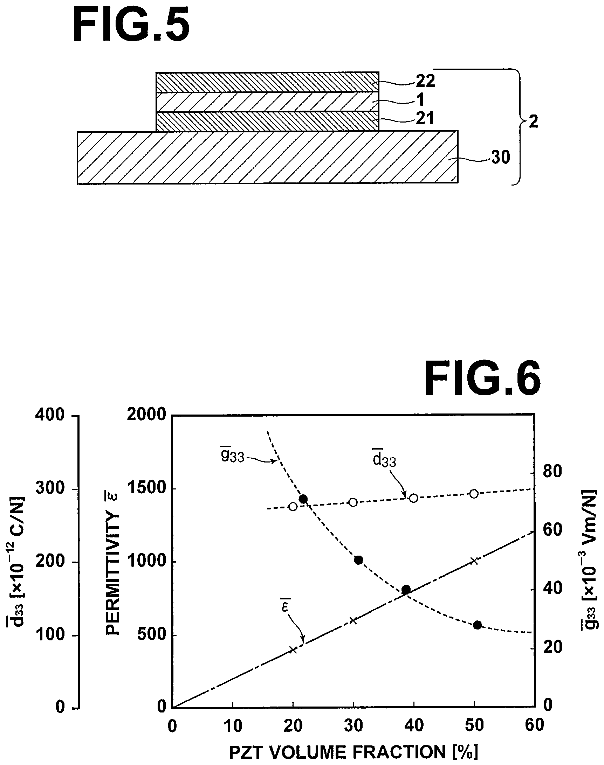

In general, in the 1-3 piezoelectric composite 1a, the columnar piezoelectric material bodies 11a can easily expand when an electric field is applied since the surrounding polymer matrix is soft. FIG. 6 shows volume fraction dependency of permittivity $\varepsilon$ and piezoelectric constants $d_{33}$ and $g_{33}$ of a 1-3 composite which uses PZT as the piezoelectric material ("Ceramic Composite, Chapter 2, Ceramic-Plastic Composite Piezoelectric Material", edited by the Ceramic Society of Japan, published by Baifukan). Therefore, if a sufficient polarization treatment is carried out, an effective $d_{33}$ value of the piezoelectric composite 1a which is nearly equal to the $d_{33}$ value of the piezoelectric material bodies 11a can be provided. On the other hand, the permittivity of the piezoelectric composite 1a becomes closer to the permittivity of the piezoelectric material bodies 11a as the volume fraction of the piezoelectric material bodies 11a increases. Since the piezoelectric g-constant is reversely proportional to the permittivity, the g-constant becomes smaller as the volume fraction of the piezoelectric material bodies 11a, which have a higher permittivity than the permittivity of the polymer material, increases.

The 0-3 composite 1b shown in FIG. 1B has a structure where particle-like or whisker-like piezoelectric material bodies 11b, for example, which have no connectivity along any of x-, y- and z-directions, are dispersed in a polymer matrix 12b.

The 0-3 composite can be produced using a common method for producing a 0-3 composite or method for producing a polymer film. For example, the 0-3 composite may be produced using a method which involves mixing and kneading a piezoelectric material powder into a melt polymer matrix material and forming a film using a melt process, such as injection molding, extrusion molding, or T-die process, or using a solution film formation technique, such as casting.

Since the 0-3 composite does not have the connectivity of the piezoelectric material bodies 11b, unlike the 1-3 composite, the piezoelectric d-constant of the 0-3 composite is also influenced by the volume fraction. Therefore, it is difficult to provide the d-constant which is nearly equal to the d-constant of the piezoelectric material bodies 11b, as in the case of the 1-3 composite; however, the 0-3 composite can be provided with a better g-constant than the g-constant of the piezoelectric material bodies 11b.

For either of the 1-3 composite or the 0-3 composite, a polarization treatment may be applied to the piezoelectric composite 1a or 1b. In the case of the 1-3 composite, the piezoelectric material bodies 11a directly contact the electrodes when the 1-3 composite is used to produce a piezoelectric device as shown in FIG. 5, and therefore the polarization treatment can be applied using the electrodes after the film formation. In the case of the 0-3 composite, a uniform polarization axis can be provided by forming a film with the piezoelectric material powder, which has been subjected to the polarization treatment in advance, so that the anisotropic piezoelectric material bodies 11a are oriented in a certain direction. Thus, even higher piezoelectric performance (d-constant) can be provided.

As stated in the "Description of the Related Art" section, in the fields of application to which the piezoelectric composite is applied, piezoelectric materials with a sufficient piezoelectric distortion constant (d-constant), which is indicative of an amount of distortion per unit electric field (transmission capability), and a sufficient g-constant, which is indicative of an intensity of induced electric field per unit stress (reception capability), or piezoelectric materials with the d-constant and the g-constant which are well-balanced are demanded. Therefore, the piezoelectric material bodies 11a used may have a high piezoelectric d-constant and may have relatively low permittivity, which provides a relatively high g-constant.

Although the piezoelectric composites having the 1-3 connectivity and the 0-3 connectivity have been described above, the connectivity type may be selected as appropriate according to required performance. The difference of performance depending on the connectivity type is described in literature pertaining to the piezoelectric composite, such as the above-mentioned literature edited by the Ceramic Society of Japan.

Further, the piezoelectric composites 1a and 1b may contain an additive, etc. For example, if the piezoelectric composite is applied to a damping material (damper), the piezoelectric composite may contain a conducting particle, such as carbon black, carbon nanotube or a metal particle, to adjust electric conductivity thereof. With this, a series circuit is formed between the piezoelectric material and the conducting particle, thereby efficiently converting vibration energy into thermal energy. The additive is not limited to a conductive substance. Any additive having a desired property may be used depending on the application.

The polymer matrix 12 (12a, 12b) is not particularly limited as long as it is an organic polymer resin. Examples thereof include: commodity plastics, such as polyethylene, polypropylene, polyvinyl chloride, polystyrene, polytetrafluoroethylene (PTFE), ABS resin (acrylonitrile-butadiene-styrene resin) and acrylic resin; engineering plastics, such as polyamide, polycarbonate, polyethylene terephthalate (PET) and thermoplastic polyimide; synthetic rubbers, such as acrylic rubber, acrylonitrilebutadiene rubber, isoprene rubber, urethane rubber, butadiene rubber and silicone rubber; piezoelectricity polymers, such as polyvinylidene fluoride (PVDF) and copolymers thereof; and thermosetting resins, such as phenolic resin, epoxy resin, melamine resin and polyimide. As the polymer matrix 12, one having preferred physical properties may be selected depending on the use and the production process of the piezoelectric composite, and one having good connectivity with the piezoelectric material bodies 11 (11a, 11b) is preferred.

Now, the piezoelectric material bodies 11a, 11b (hereinafter referred to as a "piezoelectric material 11") used in the piezoelectric composite 1 of this embodiment and a material design method thereof are described.

As stated in the "Description of the Related Art" section, the piezoelectric material 11 used in the invention is a lead-free piezoelectric material, which does not contain highly toxic Pb. The present inventors have repeated study of material design of lead-free perovskite oxides having high piezoelectric performance, and have first found a composition of a lead-free perovskite oxide which has high piezoelectric performance nearly equal to the piezoelectric performance of lead-based perovskite oxides.

There are some types of piezoelectric distortion, including:

(i) common electric field-induced piezoelectric distortion (intrinsic piezoelectric distortion), where expansion and contraction occur along the direction of the applied electric field due to increase and decrease of the intensity of the applied electric field when the vector component of the spontaneous polarization axis and the direction of the applied electric field coincide with each other;

(ii) piezoelectric distortion that occurs when the polarization axis reversibly rotates by an angle other than 180° due to increase and decrease of the intensity of the applied electric field;

(iii) piezoelectric distortion that uses change of volume due to phase transition of the crystal, which is caused by increase and decrease of the intensity of the applied electric field; and

(iv) piezoelectric distortion using an engineered domain effect, which is achieved by forming an oriented crystal structure including a ferroelectric phase that has a crystal orientation along a direction different from the direction of the spontaneous polarization axis by using a material that undergoes phase transition when an electric field is applied, thereby achieving a larger distortion (in the case where the engineered domain effect is used, the piezoelectric material may be driven under conditions where the phase transition occurs, or may be driven within a range where the phase transition does not occur).

The piezoelectric distortion of the type (i) is intrinsic piezoelectric distortion, and those of types (ii) to (iv) are extrinsic piezoelectric distortion. Each of the types (i) to (iv) can provide a larger piezoelectric distortion when a composition and an oriented crystal structure conforming to the principle of the distortion are provided. The piezoelectric distortion types (i) to (iv) may be used singly or in combination.

It has been reported that, for bulk ceramics of lead-based perovskite oxides with MPB compositions, the piezoelectric distortion constant (d-constant) is correlated with a difference $|M_A-M_B|$ between an average atomic mass $M_A$ of the A-site element and an average atomic mass $M_B$ of the B-site element, where the greater the difference $|M_A-M_B|$, the greater the electromechanical coupling coefficient k, and the greater the d-constant (Y. Hosono and Y. Yamashita, "High-Efficiency Piezoelectric Single Crystals", Toshiba Review, Vol. 59, No. 10, p.41, 2004). The present inventors have found that there is a similar correlation for lead-free perovskite oxides.

It is therefore believed that a piezoelectric material having a better piezoelectric distortion constant can be provided by selecting the A-site element and the B-site element to achieve a larger difference $|M_A-M_B|$. For example, as the A-site element, an element with the mass $M_A$ as large as possible may be selected, and as the B-site element, an element with the mass $M_B$ as small as possible may be selected. Judging from the values of $|M_A-M_B|$ of the lead-based perovskite oxides described in the above-mentioned literature, the value of $|M_A-M_B|$ may preferably be greater than 145.

Elements that may be included at each site of a perovskite oxide are almost limited by the ion radius and the ionic valence.

The present inventors have reported in U. S. Patent Application Publication No. 20100103226 that lead-free perovskite oxides containing Bi (atomic mass: 209.0) as the main component at the A-site, which have a composition designed to be at the morphotropic phase boundary (MPB) and in the vicinity of the MPB, achieved a high electromechanical coupling coefficient $k_{33}$ value and excellent piezoelectric performance. The "vicinity of the MPB" refers to an area that undergoes phase transition when an electric field is applied.

The present inventors assumed that the contribution of the mass difference between the A-site element and the B-site element to the piezoelectric performance is not limited to the MPB compositions, and have found that a lead-free piezoelectric material with a high d-constant can be achieved by including Bi (209.0) (the numerical value in parenthesis is the atomic mass) as the A-site element having a large mass and allowing material design to achieve the value of $|M_A-M_B|$ greater than 145, specifically, by providing a lead-free piezoelectric material including a perovskite oxide (which may contain inevitable impurities) having a composition represented by general formula (PX) below:

$$(Bi_x,A_{1-x}) (B_y,C_{1-y})O_3 \qquad (PX),$$

wherein A represents an A-site element with an average ionic valence of two other than Pb, B represents a B-site element with an average ionic valence of three, C represents a B-site element with an average ionic valence greater than three, each of A, B and C is one or two or more metal elements, O is oxygen, B and C have different compositions from each other, $0.6 \leq x \leq 1.0$, $x-0.2 \leq y \leq x$, and a ratio of a total mole number of the A-site element to a mole number of the oxygen atom and a ratio of a total mole number of the B-site element to the mole number of the oxygen atom are respectively 1:3 as a standard; however, these ratios may be varied from the standard molar ratio within a range where a perovskite structure is provided.

As shown in formula (PX), the A-site element may include only Bi, or may include another A-site element A other than Pb with an average ionic valence of two. The A-site element A may be at least one metal element selected from the group consisting of Mg, Ca, Sr, Ba, (Na, Bi) and (K, Bi).

Further, since the main component (at least 60 mol%) of the A-site is Bi with the ionic valence of three (trivalent), the B-site element B is a metal element with an average ionic valence of three, and may be a small mass element. The B-site element B may be at least one metal element selected from the group consisting of Al, Sc, Cr, Mn, Fe, Co, Ni, Cu, Ga, Y, In and Re (rare earth element).

If the A-site element A is included, since the A-site element A has the average ionic valence of two, the same mole number of metal element that has an average ionic valence of four may be included as the B-site element C. If the B-site element C exceeds the same mole number, the B-site element C serves as a donor/dopant. The B-site element C may be contained up to 20%. The B-site element C may include an element with an average ionic valence greater than four. In this case, the element C with the average ionic valence greater than four serves as a donor/dopant even when the mole number thereof is the same as the mole number of the element A. The B-site element C serving as a dopant may be contained up to 20%. If the A-site element A is not included, the B-site element C serves as a donor/dopant when the average ionic valence is four or more. The B-site element C serving as a dopant may, for example, be Nb or Mn.

Further, the perovskite oxide represented by general formula (PX) above may have a composition that provides a piezoelectric distortion constant $d_{33}$ (pm/V) and a specific permittivity $\varepsilon_{33}$ of the piezoelectric material 11 satisfying expressions (1) and (2) below :

$$100 < \varepsilon_{33} < 1500 \qquad (1),$$

$$d_{33} \ (pm/V) \ > \ 12\sqrt{\varepsilon_{33}} \qquad\qquad (2).$$

It is known that, in general, the piezoelectric distortion constant $d_{33}$ (pm/V) of the longitudinal vibration mode of the above described common electric field-induced piezoelectric distortion of the type (i) (intrinsic piezoelectric distortion) and the specific permittivity $\varepsilon_{33}$ have the following relationship:

$$d_{33} \ = \ k_{33}\sqrt{s}\sqrt{\varepsilon_0}\sqrt{\varepsilon_{33}},$$

and the voltage output constant $g_{33}$ is calculated as follows:

$$g_{33} \ = \ d_{33}/\varepsilon_0\varepsilon_{33}.$$

That is, in the case of the intrinsic piezoelectric distortion, if $\alpha = k_{33}\sqrt{s}\sqrt{\varepsilon_0}$, $d_{33}$ is proportional to $\sqrt{\varepsilon_{33}}$, and $g_{33}$ is reversely proportional to $\sqrt{\varepsilon_{33}}$ ($k_{33}$ is an electromechanical coupling coefficient, $\varepsilon_0$ is a permittivity in vacuum (N/V$^2$), and s is an elastic compliance (m$^2$/N)).

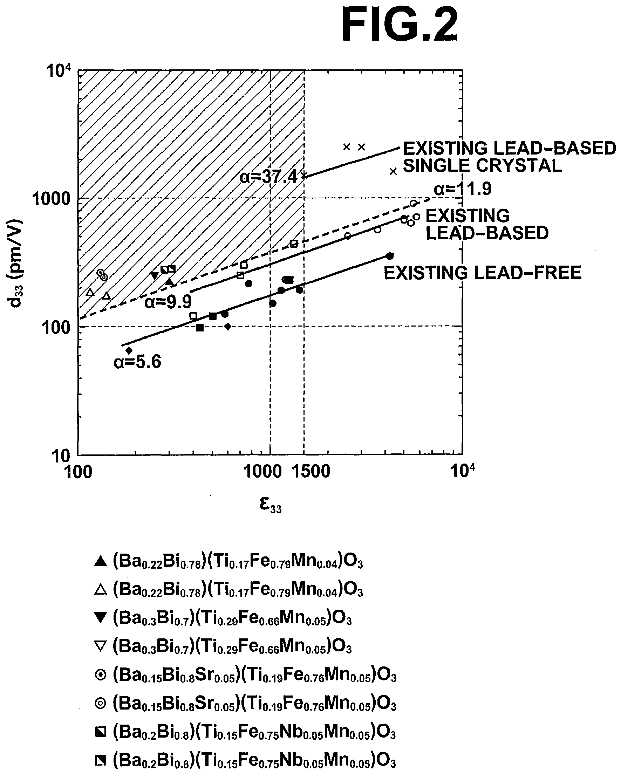

Further, for known materials developed so far and the materials invented and disclosed by the present inventors which provide high intrinsic piezoelectric distortion, it has been confirmed for both lead-based (Pb) materials and lead-free materials that $d_{33}$ is nearly proportional to $\sqrt{\varepsilon_{33}}$ (see FIG. 2).

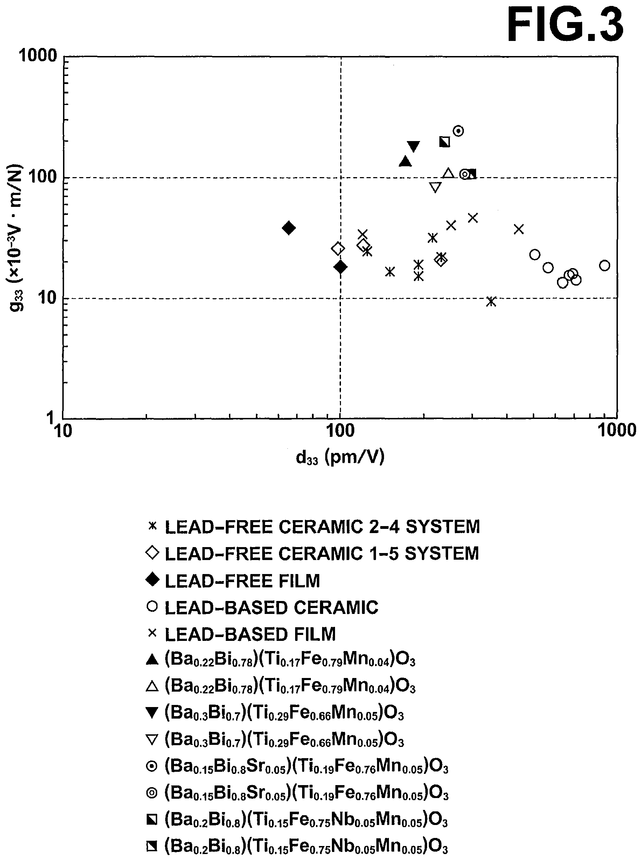

However, as a result of study of composition, production process, orientation, etc., conducted by the present inventors to achieve the above-described purpose, the present inventors have succeeded in producing a piezoelectric material which exhibits characteristics largely deviating from the straight line shown in FIG. 2, namely, the piezoelectric material 11 which exhibits a larger $d_{33}$ value than those of conventional materials while exhibiting the same level of permittivity $\varepsilon_{33}$, and thus satisfies expressions (1) and (2) above, thereby satisfying expressions (3) and (4) below. This means that the piezoelectric material 11 has good $d_{33}$ and $g_{33}$ values, i.e., good transmission capability and reception capability. (See FIG. 3, where compositions are described in the drawing. See Japanese Patent Application No. 2009-162423 for detail.)

$$100 \ < \ d_{33} \ (pm/V) \qquad\qquad (3),$$

$$80 \ < \ g_{33} \ (\times 10^{-3} \ V{\cdot}m/N) \qquad\qquad (4),$$

wherein $g_{33}$ is a voltage output constant (piezoelectric sensitivity constant) of the piezoelectric material.

As has been described above, for perovskite oxides, the greater the mass difference $|M_A-M_B|$ between the A-site ion and the B-site ion, the greater the electromechanical coupling coefficient, and the greater the d-constant. On the other hand, since the elastic compliance s is an inverse of the Young's modulus, the d-constant can be improved to some extent by selecting a material with a relatively low Young's modulus; however, the range of this value is fixed to some extent depending on the material. Therefore, in order to increase the $d_{33}$ value without increasing the specific permittivity, it is preferred to increase the $k_{33}$ value.

For example, in general formula (PX) above, the d-constant can be increased without significantly increasing the specific permittivity by including $BaTiO_3$ as the first component and $BiFeO_3$ as the second component. Since $BiFeO_3$ has a rhombohedral crystal system and $BaTiO_3$ has a tetragonal crystal system, the perovskite oxide containing these two components can form a MPB composition. Therefore, a higher d-constant can be achieved using the piezoelectric distortion types iii) and iv) described above.

In a case where the MPB composition is provided, the composition may satisfy expression (5) below. Optionally, the composition may contain a third component D that satisfies expression (6) below. Further optionally, the third component D may satisfy expression (7) below. The third component D is one of the oxides, $BiBO_3$ or $ACO_3$, in general formula (PX).

$$0.97 \ \leq \ TF(PX) \ \leq \ 1.02 \qquad\qquad (5),$$

$$TF(BiFeO_3) < TF(D) < TF(BaTiO_3) \qquad (6),$$

$$0.97 \le TF(D) \le 1.02 \qquad (7),$$

wherein TF(PX) is a tolerance factor of the oxide represented by general formula (PX), and $TF(BiFeO_3)$, TF(D) and $TF(BaTiO_3)$ are tolerance factors of the oxides in parentheses, respectively.

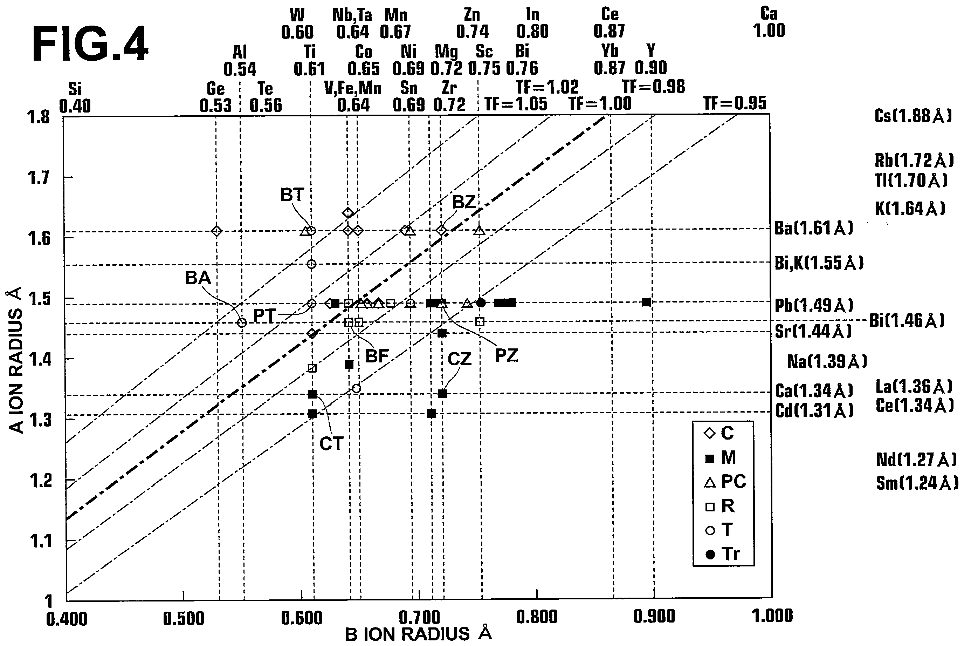

FIG. 4 is a graph showing a relationship among the average ion radius of the A-site element, the average ion radius of the B-site element, the tolerance factor TF and the crystal system for various perovskite oxides, which have the A-site formed by one or two elements and the B-site formed by one or two elements. The symbols used in the drawing to represent the crystal systems are as follows: C stands for cubic crystal, M stands for monoclinic crystal, PC stands for pseudocubic crystal, R stands for rhombohedral crystal, T stands for tetragonal crystal, and Tr stands for trigonal crystal. With respect to "Mn" appearing at two positions in FIG. 4, the ion radius of 0.64 Å is that of trivalent Mn, and the ion radius of 0.67 Å is that of divalent Mn.

When TF = 1.0, the crystal lattice of the perovskite structure is closest packing. Under this condition, the B-site element scarcely moves in the crystal lattice, and tends to provide a stable structure. This composition tends to assume a cubic or pseudocubic crystal structure, and exhibits no ferroelectricity or a very low level of ferroelectricity.

When TF > 1.0, the B-site element is smaller than the A-site element. Under this condition, the B-site element tends to be incorporated into the crystal lattice even when the crystal lattice is not distorted, and the B-site element tends to move within the crystal lattice. This composition tends to assume a tetragonal crystal structure (the spontaneous polarization axis is in the <001> direction), or the like, and has ferroelectricity. The ferroelectricity tends to increase as deviation of the TF value from 1.0 increases.

When TF < 1.0, the B-site element is larger than the A-site element. Under this condition, the B-site element is incorporated into the crystal lattice only when the crystal lattice is distorted. This composition tends to assume an orthorhombic crystal structure (the spontaneous polarization axis is in the <110> direction), a rhombohedral crystal structure (the spontaneous polarization axis is in the <111> direction), or the like, and has ferroelectricity. The ferroelectricity tends to increase as deviation of the TF value from 1.0 increases.

Table 1 below shows, for existing various mixed crystals of the first component with TF > 1.0 and the second component with TF < 1.0, crystal system / A-site ion radius / B-site ion radius / TF of each single component; ratios (molar ratios) of the first component and the second component forming the morphotropic phase boundary (MPB); and A-site average ion radius / B-site average ion radius / TF of the mixed crystals of the first component and the second component of each MPB composition. The symbols used in Table 1 to represent the crystal systems are as follows: T stands for tetragonal crystal, O stands for orthorhombic crystal and R stands for rhombohedral crystal.

As can be seen from Table 1, TF values of the MPB compositions are within a range from 0.97 to 1.02. Therefore, by providing a composition that satisfies expression (5), i.e., $0.97 \le TF(PX) \le 1.02$, the piezoelectric material 11 having a composition at the MPB or in the vicinity of the MPB can be provided.

Table 1

| | | TF>1 | | | | | TF<1 | | | | | | MPB | | |
|---|---|---|---|---|---|---|---|---|---|---|---|---|---|---|---|
| | | Crystal system | A ion radius | B ion radius | TF | Ratio | Crystal | Crystal system | A ion radius | B ion radius | TF | Ratio | A ion radius | B ion radius | TF |
| PT-PZ | $PbTiO_3$ | T | 1.49 | 0.605 | 1.019 | 0.48 | $PbZrO_3$ | R | 1.49 | 0.72 | 0.964 | 0.52 | 1.49 | 0.66 | 0.990 |
| PT-PS | $PbTiO_3$ | T | 1.49 | 0.605 | 1.019 | 0.45 | $PbSnO_3$ | R | 1.49 | 0.69 | 0.978 | 0.55 | 1.49 | 0.65 | 0.996 |
| PT-BiS | $PbTiO_3$ | T | 1.49 | 0.605 | 1.019 | 0.65 | $BiScO_3$ | R | 1.46 | 0.745 | 0.943 | 0.35 | 1.48 | 0.65 | 0.991 |
| BT-BiNT | BT | T | 1.61 | 0.605 | 1.062 | 0.15 | $(Bi,Na)TiO_3$ | R | 1.425 | 0.605 | 0.996 | 0.85 | 1.45 | 0.61 | 1.006 |
| BT-BiNT | BT | T | 1.61 | 0.605 | 1.062 | 0.07 | $(Bi,Na)TiO_3$ | R | 1.425 | 0.605 | 0.996 | 0.93 | 1.44 | 0.61 | 1.001 |
| BT-BiNT | $(Bi,K)TiO_3$ | T | 1.55 | 0.605 | 1.041 | 0.20 | $(Bi,Na)TiO_3$ | R | 1.425 | 0.605 | 0.996 | 0.80 | 1.45 | 0.61 | 1.005 |
| KN-NN | $KNbO_3$ | O | 1.64 | 0.64 | 1.054 | 0.49 | $KNbO_3$ | O | 1.39 | 0.64 | 0.967 | 0.51 | 1.51 | 0.64 | 1.010 |

Since the TF value of the above-mentioned first component $BaTiO_3$ is TF = 1.059 and the TF value of the second component $BiFeO_3$ is TF = 0.989, the first component with TF > 1.0 and the second component with TF < 1.0 are contained. From this, it can be seen that a system containing these two components can form the MPB. Therefore, by adjusting the composition ratios of the first and second components or adjusting the composition ratios of the first and second components and the third component D to achieve the TF of the entire composition of general formula (PX) in the range from 0.97 to 1.02, a perovskite oxide with the MPB composition can be provided.

As the third component, specifically, the A-site element thereof may be La, Ca, Sb, Bi, Si or Sr, for example, and the B-site element thereof may be Nd, Nb, Ta, Cr, Fe or Sc, for example.

For example, the third component may be $SrTiO_3$. Since $SrTiO_3$ has TF = 1.002, which is nearly 1.0 (within the range from 0.97 to 1.01), when $SrTiO_3$ is added to $BaTiO_3$ and $BiFeO_3$, TF of the entire composition within the range from 0.97 to 1.01 can be achieved. Another example of the third component besides $SrTiO_3$ is $CaTiO_3$.

It is known to improve electrical properties by adding a dopant to the A-site and the B-site. Examples of the element serving as the dopant may include, besides previously mentioned Nb and Mn, metal ions, such as Mg, Ca, Sr, Ta, W and Ln (= lanthanide elements (La, Ce, Pr, Nd, Sm, Eu, Gd, Tb, Dy, Ho, Er, Tm, Yb and Lu)). A part of the elements forming the third component may serve as the dopant for each site.

$BiFeO_3$ is known as a material having a high Curie temperature. Therefore, the higher the composition of $BiFeO_3$ in general formula (PX), the higher the Curie temperature of the piezoelectric material 11. Therefore, applicability under a high temperature atmosphere is increased, and thermal stability at room temperature is improved.

The above-described perovskite oxide may have a three-phase mixed crystal structure where three components, i.e., $BaTiO_3$, $BiFeO_3$, and the third component, are present together, may have a single phase where $BaTiO_3$, $BiFeO_3$ and the third component form a complete solid solution, or may have other structure.

The crystal system of the third component may be cubic or pseudocubic. The present inventors have found that, when the piezoelectric material 111 has the three-phase mixed crystal structure of the first to third components, the material is effective for an electric field-induced phase transition system which is proposed by the present inventors in U.S. Patent Application Publication No. 20090267998, and can provide high piezoelectric performance.

By providing the piezoelectric material 11 having the above-described composition containing $BaTiO_3$ and $BiFeO_3$ as described above and in the vicinity of the MPB composition, the piezoelectric material 11 which satisfies expressions (3) and (4) above and thus has the high d- and g-constants can be provided. As described above, the piezoelectric composite 1 uses, as the piezoelectric material 11, a piezoelectric material including the perovskite oxide (which may contain inevitable impurities) having the composition represented by general formula (PX) . This perovskite oxide has first been found by the present inventors, who have invented the material design method to provide a lead-free perovskite oxide with high piezoelectric performance (d-constant), as a composition of a lead-free perovskite oxide having high piezoelectric performance that is nearly equal to the piezoelectric performance of lead-based perovskite oxides. This perovskite oxide further has a high Curie point, and thus has good thermal stability. Therefore, according to this embodiment, the lead-free piezoelectric composite 1 which has good piezoelectric performance and good thermal stability at room temperature can be provided.

Further, the present inventors have found, through the above-described material design, the composition with the good d- and g-constants. Therefore, by using the piezoelectric material 11 (which may contain inevitable impurities) including the perovskite oxide having the composition which has the both good d- and g-constants found by the present inventors, the piezoelectric composite 1 with the d-constant and the g-constant which are sufficient and well-balanced and with higher performance than ever before can be accomplished.

*Piezoelectric Device*

Now, a piezoelectric device according to one embodiment of the invention is described with reference to the drawings. FIG. 5 is a schematic sectional view of a piezoelectric device 2. For ease of visual understanding, elements shown in the drawing are not to scale.

The piezoelectric device 2 includes, on a substrate 30, a polymer composite piezoelectric film 1 formed by the piezoelectric composite of the invention and a pair of electrodes (21, 22) for extracting an electric charge that is generated when the polymer composite piezoelectric film 1 is distorted by an external force.

The substrate 30 may be a flexible substrate in the form of a film with a film thickness not more than 200 $\mu$m, which does not impair the flexibility of the piezoelectric composite. Examples of the substrate may include polyimide, PTFE, polyethylene naphthalate, polypropylene, polystyrene, polycarbonate, polysulfone, polyallylate and polyamide, and one having appropriate heat resistance, moisture absorbency, etc., may be selected depending on the use environment of the piezoelectric device 2. If a metal foil is used as the substrate 30, the substrate 30 can also serve as the lower electrode. Examples of the metal foil may include aluminum, copper, stainless steel, nickel and tantalum.

The electrodes 21 and 22 are not particularly limited as long as they can preferably extract the electric charge generated in the polymer composite piezoelectric film 1. Examples thereof may include Sn, Al, Ni, Pt, Au, Ag, Cu, Cr and Mo. The thicknesses of the electrodes 21 and 22 are not particularly limited as long as they do not impair the flexibility of the piezoelectric composite, as with the substrate 30. The electrodes 21 and 22 may have thicknesses not more than 10 $\mu$m, although the thicknesses depend on the sizes of the electrodes 21 and 22. The electrodes 21 and 22 can be formed using a gas-phase film formation process, such as vacuum vapor deposition or sputtering, or a printing process, such as screen printing or inkjet printing.

The process used to form the polymer composite piezoelectric film 10 is not particularly limited, and the polymer composite piezoelectric film 10 can be formed using a solution film formation process, such as casting, or a fusion film formation process, such as T-die film formation. In the case where the solution film formation process is used, if the piezoelectric material bodies 11 included in the polymer composite piezoelectric film 10 have an anisotropic shape, such as a whisker-like or fiber-like shape, the long axis direction of the piezoelectric material bodies 11 can easily be oriented along the direction in which the solution is applied during the solution film formation process.

The polymer composite piezoelectric film 10 may be subjected to a polarization treatment. By orienting the anisotropic piezoelectric material bodies 11 along a certain direction as described above, high piezoelectric performance (d-constant) utilizing the orientation can be provided as is described with respect to the above-described embodiment of the piezoelectric composite.

The piezoelectric device 2 includes the above-described piezoelectric composite 1 of the invention. Therefore, the piezoelectric device 2 provides the same advantageous effect as the piezoelectric composite 1. The piezoelectric device 2 thus formed is preferably applicable to various sensors, such as ultrasonic sensor, pressure sensor, tactile sensor and distortion sensor, ultrasonic transducers, such as ultrasound probe and hydrophone, damping materials (damper) for use with vehicles, buildings, and sporting goods, such as ski and racket, and vibration-based power generation devices for use with floor, shoes or tires. The piezoelectric composite in the form of a film is most suited to provide the flexibility.

EXAMPLES

Now, examples according to the invention are described.

*Example 1*

First, $BaTiO_3$, $Bi_2O_3$, $Fe_2O_3$, $Mn_2O_3$ and $Nb_2O_5$ were blended as starting materials to form a composition of $(Ba_{0.2},Bi_{0.8})(Ti_{0.2},Fe_{0.78},Nb_{0.01},Mn_{0.01})O_3$. At this time, $Bi_2O_3$ was in excess of 0.5 mol%. The blended powders of starting materials were wet-mixed in ethanol using a ball mill to produce a mixed powder. After the mixing, the mixed powder was dried and shaped, and then was pre-fired at 750°C for 3 hours, and then was ground and press-formed using PVA (polyvinyl alcohol) as a binder.

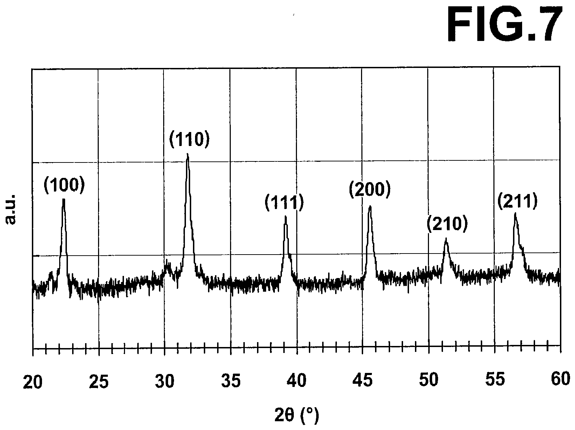

The thus provided shaped product was fired at 930°C for 10 hours and then ground and sieved using a 400 mesh ($\mu$m) sieve to provide a piezoelectric ceramic powder. The composition of the resulting powder was measured using ICP, and it was confirmed that the target composition was provided. Further, as shown in FIG. 7, it was confirmed that the resulting powder was a single perovskite phase.

Subsequently, uncured silicone rubber was prepared and the piezoelectric ceramic powder was added thereto by an amount of about 70 vol.%, and was sufficiently mixed using a mill. The resulting mixture was subjected to vulcanizing press using a pressing machine to provide a polymer composite piezoelectric material (piezoelectric rubber) having a size of 100 mm $\times$ 100 mm and a thickness of 0.5 mm.

*Comparative Example 1*

A PZT polymer composite piezoelectric material (piezoelectric rubber) was produced in the same manner as in Example 1, except that the composition of the piezoelectric ceramic was $Pb(Ti_{0.48}, Zr_{0.52})O_3$, starting materials were PbO, $TiO_2$ and $ZrO_2$, and the PbO was in excess of 0.5 mol%.

*Evaluation 1*

Each of the PZT polymer composite piezoelectric material (piezoelectric rubber) produced in Example 1 and Comparative Example 1 was cut into pieces of an appropriate size. Then, a silver paste was applied on opposite sides of each piece to form an electrode, and a polarization treatment was applied. Then, permittivity $\varepsilon_{33}$ and the effective piezoelectric constant $d_{33}$ of the thus provided measurement samples were measured. The permittivity was measured using an impedance analyzer (4294A manufactured by Agilent), and the effective piezoelectric constant $d_{33}$ was measured using a laser displacement meter (LV-1720A manufactured by Ono Sokki Co., Ltd.)

Table 2 shows the results of measurement of the electrical properties with respect to Example 1 and Comparative Example 1. Although the piezoelectric rubber of the Example had a smaller $d_{33}$ value than that of the piezoelectric rubber of the Comparative Example, the piezoelectric rubber of the Example had a smaller permittivity value, and therefore a larger $g_{33}$ value than those of the piezoelectric rubber of the Comparative Example. Thus, the piezoelectric rubber of the Example had a larger $d_{33}*g_{33}$ value, which is indicative of the power generation performance, than that of the piezoelectric rubber of the Comparative Example, and was found to be suitable as a power generation device.

Table 2

| | $\varepsilon_{33}$ | $d_{33}$ (pC/N) | $g_{33}$ (mVm/N) | $d_{33}*g_{33}$ ($10^{-15}$VCm/N$^2$) |
|---|---|---|---|---|
| Example 1 | 25 | 40 | 181 | 7228 |
| Comparative Example 1 | 70 | 60 | 97 | 5809 |

*Example 2*

A blend of powders was prepared in the same manner as in Example 1, except that $BaTiO_3$, $SrTiO_3$, $Bi_2O_3$, $Fe_2O_3$ and $Mn_2O_3$ were blended as starting materials to form a composition of $(Ba_{0.3}, Bi_{0.65}, Sr_{0.05})(Ti_{0.35}, Fe_{0.62}, Mn_{0.03})O_3$. After mixing, the mixed powder was dried and shaped, and then was pre-fired at 900°C for 5 hours, and then was ground and press-formed using PVA as a binder.

The thus provided shaped product was fired at 950°C for 10 hours and then ground and sieved using a 400 mesh (37 $\mu$m) sieve to provide a piezoelectric ceramic powder. The composition of the resulting powder was measured using ICP, and it was confirmed that the target composition was provided. Further, it was confirmed through XRD that the resulting powder was a single perovskite phase.

Subsequently, a solution of cyanoethyl resin dissolved in a solvent was prepared, and the above-obtained ceramic powder was added to the solution by an amount of 60 vol.% of the cyanoethyl resin, and was sufficiently mixed using a stirring and defoaming device. The resulting mixture was coated on a 200 $\mu$m-thick aluminum foil using a coater and dried at 120°C to provide a 0.1 mm-thick polymer composite piezoelectric material having a size of 50 mm x 50 mm.

*Example 3*

A polymer composite piezoelectric material was produced in the same manner as in Example 2, except that starting materials were blended to provide a piezoelectric ceramic composition of $(Ba_{0.2}, Bi_{0.75}, Sr_{0.05})(Ti_{0.25}, Fe_{0.72}, Mn_{0.03})O_3$.

*Comparative Example 2*

A PZT polymer composite piezoelectric material was produced in the same manner as in Example 2, except that PbO, $TiO_2$ and $ZrO_2$, where PbO was 0.5 mol% excess, were blended as starting materials to provide a piezoelectric ceramic composition of $Pb(Ti_{0.48}, Zr_{0.52})O_3$.

*Evaluation 2*

Each of polymer composite piezoelectric material (piezoelectric rubber) produced in Example 2, Example 3 and Comparative Example 1 was cut into pieces of an appropriate size. Then, an aluminum electrode was formed on the upper surface of each piece through sputtering and a polarization treatment was applied. Then, permittivity $\varepsilon_{33}$ and the effective piezoelectric constant $d_{33}$ of the thus provided measurement samples were measured using the same devices as in Evaluation 1.

Table 3 shows the results of measurement of the electrical properties. Example 2 satisfied $d_{33} > 12\sqrt{\varepsilon_{33}}$ and thus had higher piezoelectric performance than that of Example 3. Although Example 2 had smaller $d_{33}$ than that of Comparative Example 2, it had smaller permittivity and thus had lager $g_{33}$. Therefore, Example 2 had larger $d_{33}*g_{33}$, which is indicative of the power generation performance, and was found to be suitable as a power generation device.

Table 3

| | Piezoelectric Material | | | Polymer Composite Piezoelectric Material | | | |
|---|---|---|---|---|---|---|---|
| | E33 | $d_{33}$ (pC/N) | $12\sqrt{\varepsilon_{33}}$ | $\varepsilon_{33}$ | $d_{33}$ (pC/N) | $g_{33}$ (mVm/N) | $d_{33}*g_{33}$ ($10^{-15}$VCm/N$^2$) |
| Example 2 | 540 | 290 | 279 | 70 | 70 | 113 | 7906 |

(continued)

| | Piezoelectric Material | | | Polymer Composite Piezoelectric Material | | | |
|---|---|---|---|---|---|---|---|
| | E33 | $d_{33}$ (pC/N) | $12\sqrt{\varepsilon_{33}}$ | $\varepsilon_{33}$ | $d_{33}$ (pC/N) | $g_{33}$ (mVm/N) | $d_{33}*g_{33}$ ($10^{-15}$VCm/N$^2$) |
| Example 3 | 420 | 150 | 246 | 50 | 40 | 90 | 3614 |
| Comparative Example 2 | 1200 | 310 | 416 | 120 | 80 | 75 | 6024 |

Industrial Applicability

The polymer composite piezoelectric material of the invention is preferably applicable to various sensors, such as ultrasonic sensor, pressure sensor, tactile sensor and distortion sensor, ultrasonic transducers, such as ultrasound probe and hydrophone, damping materials (damper) for use with vehicles, buildings, and sporting goods, such as ski and racket, and vibration-based power generation devices for use with floor, shoes or tires.

**Claims**

1. A polymer composite piezoelectric material (1, 1a, 1b) comprising:

   a matrix (12a, 12b) comprising an organic polymer resin; and
   a piezoelectric material (11a, 11b) included in the matrix (12a, 12b), the piezoelectric material (11a, 11b) comprising a perovskite oxide having a composition represented by general formula (PX) below:

   $$(Bi_x, A_{1-x})(B_y, C_{1-y})O_3 \qquad (PX),$$

   wherein A represents an A-site element with an average ionic valence of two other than Pb, B represents a B-site element with an average ionic valence of three, C represents a B-site element with an average ionic valence greater than three, each of A, B and C is one or two or more metal elements, O is oxygen, B and C have different compositions from each other, $0.6 \leq x \leq 1.0$, $x-0.2 \leq y \leq x$, and a ratio of a total mole number of the A-site element to a mole number of the oxygen atom and a ratio of a total mole number of the B-site element to the mole number of the oxygen atom are respectively 1:3 as a standard; however, these ratios may be varied from the standard molar ratio within a range where a perovskite structure is provided.

2. The polymer composite piezoelectric material (1, 1a, 1b) as claimed in claim 1, wherein the A-site element A comprises at least one metal element selected from the group consisting of Mg, Ca, Sr, Ba, (Na, Bi) and (K, Bi).

3. The polymer composite piezoelectric material (1, 1a, 1b) as claimed in claim 1 or 2, wherein the B-site element B comprises at least one metal element selected from the group consisting of Al, Sc, Cr, Mn, Fe, Co, Ni, Cu, Ga, Y, In and Re (rare earth element).

4. The polymer composite piezoelectric material (1, 1a, 1b) as claimed in any one of claims 1 to 3, wherein a piezoelectric distortion constant $d_{33}$ (pm/V) and a specific permittivity $\varepsilon_{33}$ of the piezoelectric material (11a, 11b) satisfy expressions (1) and (2) below:

   $$100 < \varepsilon_{33} < 1500 \qquad (1),$$

   $$d_{33} \ (pm/V) > 12\sqrt{\varepsilon_{33}} \qquad (2).$$

5. The polymer composite piezoelectric material (1, 1a, 1b) as claimed in claim 4, wherein the piezoelectric distortion constant $d_{33}$ and a voltage output constant $g_{33}$ of the piezoelectric material (11a, 11b) satisfy expressions (3) and (4) below:

$$100 < d_{33} \ (\text{pm/V}) \hspace{3cm} (3),$$

$$80 < g_{33} \ (\times 10^{-3} \ \text{V·m/N}) \hspace{2.5cm} (4).$$

6. The polymer composite piezoelectric material (1, 1a, 1b) as claimed in any one of claims 1 to 5, wherein the perovskite oxide comprises $BaTiO_3$ as a first component and $BiFeO_3$ as a second component.

7. The polymer composite piezoelectric material (1, 1a, 1b) as claimed in any one of claims 1 to 6, wherein the perovskite oxide represented by general formula (PX) comprises a first component with a tolerance factor greater than 1.0 and a second component with a tolerance factor smaller than 1.0, and satisfies expression (5) below:

$$0.97 \leq TF(PX) \leq 1.02 \hspace{2.5cm} (5),$$

wherein TF(PX) is a tolerance factor of the oxide represented by general formula (PX).

8. The polymer composite piezoelectric material (1, 1a, 1b) as claimed in any one of claims 1 to 7, wherein a difference $|M_A\text{-}M_B|$ between an average atomic mass $M_A$ of the A-site element and an average atomic mass $M_B$ of the B-site element is greater than 145.

9. The polymer composite piezoelectric material (1, 1a, 1b) as claimed in any one of claims 1 to 8 having 1-3 connectivity.

10. The polymer composite piezoelectric material (1, 1a, 1b) as claimed in any one of claims 1 to 9 in the form of a polymer composite piezoelectric film.

11. A piezoelectric device (2) comprising:

the polymer composite piezoelectric material (1, 1a, 1b) as claimed in any one of claims 1 to 10; and
a pair of electrodes (21, 22) for extracting an electric charge, the electric charge being generated when the piezoelectric material is distorted by an external force.

**Patentansprüche**

1. Piezoelektrisches Polymerverbundmaterial (1, 1a, 1 b) aufweisend:

eine Matrix (12a, 12b), die ein organisches Polymerharz aufweist; und
ein in der Matrix (12a, 12b) enthaltenes piezoelektrisches Material (11a, 11b), wobei das piezoelektrische Material (11a, 11b) ein Perovskitoxid aufweist, das eine Zusammensetzung hat, die durch die allgemeine Formel (PX) unten repräsentiert wird:

$$(Bi_x, A_{1\text{-}x}) \ (B_y, C_{1\text{-}x})O_3 \hspace{2cm} (PX),$$

worin A ein von Pb verschiedenes Element an Platz A mit einer mittleren ionischen Valenz von zwei repräsentiert, B ein Element an Platz B mit einer mittleren ionischen Valenz von drei repräsentiert, C ein Element an Platz B mit einer mittleren ionischen Valenz von größer als drei repräsentiert, wobei A, B und C jeweils für ein oder zwei oder mehr Metallelemente steht, O Sauerstoff ist, B und C voneinander verschiedene Zusammensetzungen haben, $0,6 \leq x \leq 1,0$, $x - 0,2 \leq y \leq x$, und wobei ein Verhältnis einer Gesamtmolzahl des Elements an Platz A zu einer Molzahl des Sauerstoffatoms und ein Verhältnis einer Gesamtmolzahl des Elements an Platz B zu der Molzahl des Sauerstoffatoms jeweils 1:3 als Norm sind; wobei jedoch diese Verhältnisse innerhalb eines Bereichs, in dem eine Perovskitstruktur gebildet wird, von dem Normmolverhältnis abweichen können.

2. Piezoelektrisches Polymerverbundmaterial (1, 1a, 1b) wie in Anspruch 1 beansprucht, wobei das Element A an Platz A mindestens ein Metallelement aufweist, das ausgewählt ist aus der Gruppe, die aus Mg, Ca, Sr, Ba, (Na, Bi) und (K, Bi) besteht.

3. Piezoelektrisches Polymerverbundmaterial (1, 1a, 1b) wie in Anspruch 1 oder 2 beansprucht, wobei das Element B an Platz B mindestens ein Metallelement aufweist, das ausgewählt ist aus der Gruppe, die aus Al, Sc, Cr, Mn, Fe, Co, Ni, Cu, Ga, Y, In und Re (Seltenerdelement) besteht.

4. Piezoelektrisches Polymerverbundmaterial (1, 1a, 1b) wie in einem der Ansprüche 1 bis 3 beansprucht, wobei eine piezoelektrische Verformungskonstante $d_{33}$ (pm/V) und eine spezifische Permittivität $\varepsilon_{33}$ des piezoelektrischen Materials (11a, 11b) die Ausdrücke (1) und (2) unten erfüllen:

$$100 < \varepsilon_{33} < 1500 \qquad (1)$$

$$d_{33} \text{ (pm/V)} > 12 \ \sqrt{\varepsilon_{33}} \qquad (2).$$

5. Piezoelektrisches Polymerverbundmaterial (1, 1a, 1b) wie in Anspruch 4 beansprucht, wobei die piezoelektrische Verformungskonstante $d_{33}$ und eine Spannungsausgabekonstante $g_{33}$ des piezoelektrischen Materials (11a, 11b) die Ausdrücke (3) und (4) unten erfüllen:

$$100 < d_{33} \text{ (pm/V)} \qquad (3)$$

$$80 < g_{33} \ (\text{x}10^{-3} \ V \cdot m/N) \qquad (4).$$

6. Piezoelektrisches Polymerverbundmaterial (1, 1a, 1b) wie in einem der Ansprüche 1 bis 5 beansprucht, wobei das Perovskitoxid $BaTiO_3$ als eine erste Komponente und $BiFeO_3$ als eine zweite Komponente aufweist.

7. Piezoelektrisches Polymerverbundmaterial (1, 1a, 1b) wie in einem der Ansprüche 1 bis 6 beansprucht, wobei das Perovskitoxid, das durch die allgemeine Formel (PX) repräsentiert wird, eine erste Komponente mit einem Toleranzfaktor größer als 1,0 und eine zweite Komponente mit einem Toleranzfaktor kleiner als 1,0 aufweist und den Ausdruck (5) unten erfüllt:

$$0,97 \le TF(PX) \le 1,02 \qquad (5),$$

worin TF(PX) ein Toleranzfaktor des Oxids ist, das durch die allgemeine Formel (PX) repräsentiert wird.

8. Piezoelektrisches Polymerverbundmaterial (1, 1a, 1b) wie in einem der Ansprüche 1 bis 7 beansprucht, wobei eine Differenz $|M_A-M_B|$ zwischen einer mittleren Atommasse $M_A$ des Elements an Platz A und einer mittleren Atommasse $M_B$ des Elements an Platz B größer als 145 ist.

9. Piezoelektrisches Polymerverbundmaterial (1, 1a, 1b) wie in einem der Ansprüche 1 bis 8 beansprucht, das 1-3-Konnektivität hat.

10. Piezoelektrisches Polymerverbundmaterial (1, 1a, 1b) wie in einem der Ansprüche 1 bis 9 beansprucht, in der Form eines piezoelektrischen Polymerverbundfilms.

11. Piezoelektrische Vorrichtung (2) aufweisend:

das piezoelektrische Polymerverbundmaterial (1, 1a, 1b) wie in einem der Ansprüche 1 bis 10 beansprucht; und ein Paar Elektroden (21, 22) zur Entnahme einer elektrischen Ladung, wobei die elektrische Ladung erzeugt wird, wenn das piezoelektrische Material durch eine äußere Kraft verformt wird.

**Revendications**

1. Matériau piézoélectrique polymère composite (1, 1a, 1b), comprenant :

une matrice (12a, 12b) comprenant une résine polymère organique, et
un matériau piézoélectrique (11a, 11b) inclus dans la matrice (12a, 12b), le matériau piézoélectrique (11a, 11b) comprenant un oxyde de pérovskite présentant une composition représentée par la formule générale (PX) suivante :

$$(Bi_x, A_{1-x}) (B_y, C_{1-y})O_3 \qquad (PX)$$

dans lequel A représente un élément de site A présentant une valence ionique moyenne égale à deux et autre que Pb; B représente un élément de site B présentant une valence ionique moyenne égale à trois ; C représente un élément de site B présentant une valence ionique moyenne supérieure à trois ; chacun de A, B et C est un élément métallique, deux éléments métalliques ou plusieurs éléments métalliques ; O est oxygène ; B et C présentent des compositions différentes l'une de l'autre ; $0,6 \leq x \leq 1,0$, $x - 0,2 \leq y \leq x$, et un rapport entre un nombre de moles total de l'élément de site A et le nombre de moles de l'atome d'oxygène ainsi qu'un rapport entre un nombre de moles total de l'élément de site B et le nombre de moles de l'atome d'oxygène sont respectivement de 1 : 3 comme standard, ces rapports pouvant toutefois varier du rapport molaire standard dans les limites d'une plage où la structure de pérovskite est fournie.

2.  Matériau piézoélectrique polymère composite (1, 1a, 1b) selon la revendication 1, dans lequel l'élément de site A comprend au moins un élément métallique sélectionné parmi le groupe consistant en Mg, Ca, Sr, Ba, (Na, Bi) et (K, Bi).

3.  Matériau piézoélectrique polymère composite (1, 1a, 1b) selon la revendication 1 ou 2, dans lequel l'élément de site B comprend au moins un élément métallique sélectionné parmi le groupe consistant en Al, Sc, Cr, Mn, Fe, Co, Ni, Cu, Ga, Y, In et Re (élément de terres rares).

4.  Matériau piézoélectrique polymère composite (1, 1a, 1b) selon l'une quelconque des revendications 1 à 3, dans lequel une constante de distorsion piézoélectrique $d_{33}$ (pm/V) et une permittivité spécifique $\varepsilon_{33}$ du matériau piézoélectrique (11a, 11b) satisfont les expressions (1) et (2) suivantes :

$$100 < \varepsilon_{33} < 1500 \qquad (1),$$

et

$$d_{33} (pm/V) > 12\sqrt{\varepsilon_{33}} \qquad (2).$$

5.  Matériau piézoélectrique polymère composite (1, 1a, 1b) selon la revendication 4, dans lequel la constante de distorsion piézoélectrique $d_{33}$ et une constante de tension de sortie $g_{33}$ du matériau piézoélectrique (11a, 11b) satisfont les expressions (3) et (4) suivantes :

$$100 < d_{33} (pm/V) \qquad (3),$$

et

$$80 < g_{33} < (x10^{-3} \ V \cdot m/N) \qquad (4).$$

6.  Matériau piézoélectrique polymère composite (1, 1a, 1b) selon l'une quelconque des revendications 1 à 5, dans lequel l'oxyde de pérovskite comprend $BaTiO_3$ comme premier composant et $BiFeO_3$ comme second composant.

7.  Matériau piézoélectrique polymère composite (1, 1a, 1b) selon l'une quelconque des revendications 1 à 6, dans lequel l'oxyde de pérovskite représenté par la formule générale (PX) comprend un premier composant présentant un facteur de tolérance supérieur à 1,0, et un second composant présentant un facteur de tolérance inférieur à 1,0, et satisfait l'expression (5) suivante :

$$0{,}97 \leq \mathrm{TF(PX)} \leq 1{,}02 \qquad\qquad (5)$$

où FT(PX) est un facteur de tolérance de l'oxyde représenté par la formule générale (PX).

8. Matériau piézoélectrique polymère composite (1, 1a, 1b) selon l'une quelconque des revendications 1 à 7, dans lequel une différence $|M_A - M_B|$ entre une masse atomique moyenne $M_A$ de l'élément de site A et une masse atomique moyenne $M_B$ de l'élément de site B est supérieure à 145.

9. Matériau piézoélectrique polymère composite (1, 1a, 1b) selon l'une quelconque des revendications 1 à 8 présentant une connectivité 1-3.

10. Matériau piézoélectrique polymère composite (1, 1a, 1b) selon l'une quelconque des revendications 1 à 9, sous la forme d'un film piézoélectrique polymère composite.

11. Dispositif piézoélectrique (2), comprenant :

le matériau piézoélectrique polymère composite (1, 1a, 1b) selon l'une quelconque des revendications 1 à 10, et une paire d'électrodes (21, 22) destinées à extraire une charge électrique, la charge électrique étant générée lorsque le matériau piézoélectrique est déformé par une forme externe.

# FIG.1A

# FIG.1B

# FIG.2

$\blacktriangle$ $(Ba_{0.22}Bi_{0.78})(Ti_{0.17}Fe_{0.79}Mn_{0.04})O_3$

$\triangle$ $(Ba_{0.22}Bi_{0.78})(Ti_{0.17}Fe_{0.79}Mn_{0.04})O_3$

$\blacktriangledown$ $(Ba_{0.3}Bi_{0.7})(Ti_{0.29}Fe_{0.66}Mn_{0.05})O_3$

$\triangledown$ $(Ba_{0.3}Bi_{0.7})(Ti_{0.29}Fe_{0.66}Mn_{0.05})O_3$

$\odot$ $(Ba_{0.15}Bi_{0.8}Sr_{0.05})(Ti_{0.19}Fe_{0.76}Mn_{0.05})O_3$

$\circledcirc$ $(Ba_{0.15}Bi_{0.8}Sr_{0.05})(Ti_{0.19}Fe_{0.76}Mn_{0.05})O_3$

$\blacksquare$ $(Ba_{0.2}Bi_{0.8})(Ti_{0.15}Fe_{0.75}Nb_{0.05}Mn_{0.05})O_3$

$\square$ $(Ba_{0.2}Bi_{0.8})(Ti_{0.15}Fe_{0.75}Nb_{0.05}Mn_{0.05})O_3$

# FIG.3

× LEAD-FREE CERAMIC 2-4 SYSTEM

◇ LEAD-FREE CERAMIC 1-5 SYSTEM

◆ LEAD-FREE FILM

○ LEAD-BASED CERAMIC

× LEAD-BASED FILM

▲ $(Ba_{0.22}Bi_{0.78})(Ti_{0.17}Fe_{0.79}Mn_{0.04})O_3$

△ $(Ba_{0.22}Bi_{0.78})(Ti_{0.17}Fe_{0.79}Mn_{0.04})O_3$

▼ $(Ba_{0.3}Bi_{0.7})(Ti_{0.29}Fe_{0.66}Mn_{0.05})O_3$

▽ $(Ba_{0.3}Bi_{0.7})(Ti_{0.29}Fe_{0.66}Mn_{0.05})O_3$

⊙ $(Ba_{0.15}Bi_{0.8}Sr_{0.05})(Ti_{0.19}Fe_{0.76}Mn_{0.05})O_3$

◎ $(Ba_{0.15}Bi_{0.8}Sr_{0.05})(Ti_{0.19}Fe_{0.76}Mn_{0.05})O_3$

◪ $(Ba_{0.2}Bi_{0.8})(Ti_{0.15}Fe_{0.75}Nb_{0.05}Mn_{0.05})O_3$

◩ $(Ba_{0.2}Bi_{0.8})(Ti_{0.15}Fe_{0.75}Nb_{0.05}Mn_{0.05})O_3$

# FIG.4

# FIG.5

# FIG.6

FIG.7

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 3075447 B
- US 20100103226 A

- JP 2009162423 A
- US 20090267998 A

**Non-patent literature cited in the description**

- **K-H LAM et al.** *Piezoelectric and pyroelectric properties of (Bi0.5Na0.5) Ba0.06TiO3/P (VDF-TrFE) 0-3 composites,* 2005, vol. 36, 1595-1599
- **R.D. SHANNON.** Revised Effective Ionic Radii and Systematic Studies of Interatomic Distances in Halides and Chalcogenides. *Acta Crystallogr,* 1976, vol. A32, 751-767

- **R. E. NEWNHAM et al.** CONNECTIVITY AND PIEZOELECTRIC-PYROELECTRIC COMPOSITES. *Mater. Res. Bull.,* 1978, vol. 13, 525-536
- **Y. HOSONO ; Y. YAMASHITA.** High-Efficiency Piezoelectric Single Crystals. *Toshiba Review,* 2004, vol. 59 (10), 41